# EUROPÄISCHE PATENTSCHRIFT

(11) **EP 3 864 780 B1**
(45) Veröffentlichungstag und Bekanntmachung des Hinweises auf die Patenterteilung: **04.05.2022**
(21) Anmeldenummer: 19806191.3
(22) Anmeldetag: 19.11.2019
(51) Int. Cl.: H04J 3/06, H03K 23/66, G05B 19/02, H04L 12/40

(54) **VERFAHREN ZUM BETREIBEN EINES NETZWERKTEILNEHMERS IN EINEM AUTOMATISIERUNGSKOMMUNIKATIONSNETZWERK**
METHOD OF OPERATING A COMMUNICATION-NODE IN AN AUTOMATION COMMUNICATION NETWORK
PROCEDE DE FONCTIONNEMENT D'UN NOEUD DE COMMUNICATION DANS UN RESEAU DE COMMUNICATION AUTOMATISE

(30) Priorität: 20.11.2018 DE 102018129189
(43) Veröffentlichungstag der Anmeldung: 18.08.2021
(73) Patentinhaber: Beckhoff Automation GmbH, 33415 Verl (DE)
(72) Erfinder: VONNAHME, Erik, 33154 Salzkotten (DE)
(74) Vertreter: Patentanwaltskanzlei WILHELM & BECK
(86) Internationale Anmeldenummer: PCT/EP2019/081727
(87) Internationale Veröffentlichungsnummer: WO 2020/104414

(56) Entgegenhaltungen:
- WO-A1-2013/048770
- WO-A2-02/075993
- RYAN C ET AL: "Clock synchronisation on multiple TTCAN network channels", MICROPROCESSORS AND MICROSYSTEMS, IPC BUSINESS PRESS LTD. LONDON, GB, vol. 28, no. 3, 23 April 2004 (2004-04-23) , pages 135-146, XP004502590, ISSN: 0141-9331, DOI: 10.1016/J.MICPRO.2004.02.001

## Beschreibung

Die vorliegende Erfindung betrifft ein Verfahren zum Betreiben eines Netzwerkteilnehmers in einem Automatisierungskommunikationsnetzwerk.

Diese Patentanmeldung beansprucht die Priorität der deutschen Patentanmeldung 10 2018 129 189.2 .

Aus dem Stand der Technik ist es bekannt, einen Datenaustausch zwischen Netzwerkteilnehmern in einem Automatisierungskommunikationsnetzwerk mittels im Automatisierungskommunikationsnetzwerk verteilter Uhren zu synchronisieren. Beispielhaft offenbart die EP2544389B1 ein Verfahren zur Arbeitstakt- und Zeittaktsynchronisation einer untergeordneten Domain eines Automatisierungsnetzwerks.

Zum Synchronisieren eines Datenaustauschs in einem Automatisierungskommunikationsnetzwerk werden typischerweise Uhren verwendet, die dazu ausgebildet sind, Zeiten als ganzzahlige Zählwerte bereitzustellen. Der Datenaustausch im Automatisierungskommunikationsnetzwerk erfolgt mit einer festgelegten Taktfrequenz. Die Taktfrequenz kann derart festgelegt sein, dass eine Periodendauer pro Takt von den Uhren nicht als ganzzahliger Zählwert darstellbar ist. Werden die Uhren mit der Taktfrequenz inkrementiert, so ergeben sich Abweichungen der Zählwerte der Uhren von Vielfachen der Periodendauer. Abweichungen der Zählwerte der Uhren von einem Vielfachen der Periodendauer können einen synchronen Datenaustausch negativ beeinflussen.

Eine Lösung für dieses Problem besteht darin, die Uhren mit einer Frequenz zu inkrementieren, die von der Taktfrequenz abweicht und eine Taktdomäne der Uhren in eine Taktdomäne des Datenaustauschs zu transformieren. Eine solche Transformation ist allerdings nicht verzögerungsfrei. Diese Verzögerung verursacht Abweichung der von den Uhren bereitgestellten Zeiten von einer Referenzzeit. Eine solche Abweichung wird auch als Jitter bezeichnet. Ein Jitter kann beispielsweise dazu führen, dass ein im Rahmen des Datenaustauschs ausgetauschtes Datagramm mit einem inkorrekten Zeitstempel versehen wird.

WO 2013/048770 A1 (ANUE SYSTEMS INC [US]; WEBB III CHARLES A, et al; 4. April 2013) offenbart, dass ein Verhältnis zwischen der Taktrate einer Zeitstempeluhr eines untergeordneten Netzwerkteilnehmers und der Taktrate der Zeitstempeluhr des übergeordneten Netzwerkteilnehmers eine rationale Zahl sein kann. Daraus folgt, dass für eine Anzahl von Takten T der Zeitstempeluhr des übergeordneten Netzwerkteilnehmers eine Anzahl R von Takten der Zeitstempeluhr des untergeordneten Netzwerkteilnehmers vorliegt. WO02/075993 A2 (BOSCH GMBH ROBERT [DE]; FUEHRER THOMAS [DE] ET AL ; 26. September 2002) offenbart, dass mittels Taktteilung aus einem Eingangstakt ein langsamerer Ausgangstakt hergestellt werden kann, wobei die Taktperiode des Ausgangstaktes nicht nur ein ganzzahliges, sondern im Mittel auch ein gebrochen rationales Vielfaches der Taktperiode des Eingangstaktes sein kann. Darüber hinaus wird eine optionale lokale Zeitbasis offenbart.

RYAN C ET AL: "Clock synchronisation on multiple TTCAN network channels"; MICROPROCESSORS AND MICROSYSTEMS, IPC BUSINESS PRESS LTD. LONDON, GB, Bd. 28, Nr. 3, 23. April 2004 (2004-04-23), Seiten 135-146, ISSN: 0141-9331, DOI: 10.1016/J.MICPRO.2004.02.001 offenbart Synchronisierung in einem TTCAN Netzwerk.

Die Aufgabe der vorliegenden Erfindung ist es, ein verbessertes Verfahren zum Betreiben eines Netzwerkteilnehmers in einem Automatisierungskommunikationsnetzwerk anzugeben, einen Netzwerkteilnehmer, der dazu ausgebildet ist, das Verfahren durchzuführen, und ein Automatisierungskommunikationsnetzwerk mit zumindest zwei Netzwerkteilnehmern, die dazu ausgebildet sind das Verfahren durchzuführen, bereitzustellen.

Diese Aufgaben werden durch ein Verfahren zum Betreiben eines Netzwerkteilnehmers in einem Automatisierungskommunikationsnetzwerk mit den Merkmalen des unabhängigen Anspruchs 1, durch einen Netzwerkteilnehmer mit den Merkmalen des unabhängigen Anspruchs 6 und durch ein Automatisierungskommunikationsnetzwerk mit den Merkmalen des unabhängigen Anspruchs 7 gelöst. Vorteilhafte Weiterbildungen sind in abhängigen Ansprüchen angegeben.

Ein Netzwerkteilnehmer eines Automatisierungskommunikationsnetzwerks ist dazu vorgesehen, Daten mit weiteren Netzwerkteilnehmern im Automatisierungskommunikationsnetzwerk mit einer festgelegten Taktfrequenz auszutauschen. Der Netzwerkteilnehmer weist eine interne Uhr zum Synchronisieren des Datenaustauschs mit zumindest einem weiteren Netzwerkteilnehmer auf. Die interne Uhr ist dazu vorgesehen, eine Zeit als ganzzahligen Zählwert bereitzustellen. Die Taktfrequenz ist derart festgelegt, dass eine Periodendauer pro Takt von der internen Uhr nicht durch einen ganzzahligen Zählwert darstellbar ist. Ein Verfahren zum Betreiben des Netzwerkteilnehmers im Automatisierungskommunikationsnetzwerk umfasst folgenden Verfahrensschritt: Die interne Uhr wird mittels einer festgelegten Sequenz von ganzzahligen Inkrementen inkrementiert. Die Sequenz der ganzzahligen Inkremente ist derart festgelegt, dass eine Summe der ganzzahligen Inkremente einem ganzzahligen Vielfachen der Periodendauer entspricht.

Vorteilhafterweise entspricht ein Zählwert der internen Uhr nach dem Inkrementieren der internen Uhr mittels der Sequenz von Inkrementen einem idealen Zählwert der internen Uhr. Der ideale Zählwert entspricht einem Vielfachen der Periodendauer, die von der internen Uhr nicht als ganzzahliger Zählwert darstellbar ist. Nach dem Inkrementieren der internen Uhr mittels der Sequenz von Inkrementen entspricht der ideale Zählwert dem ganzzahligen Vielfachen der Periodendauer. Dadurch ist die interne Uhr zumindest nach dem Inkrementieren mittels der Sequenz von Inkrementen an die Taktfrequenz des Datenaustauschs angepasst. Abweichungen von Zählwerten der internen Uhr von idealen Zählwerten nach einzelnen Inkrementierungsschritten, d.h. bevor das Inkrementieren der internen Uhr mittels der Sequenz von Inkrementen vollständig erfolgt ist, können auf Rundungsfehler reduziert sein. Dadurch kann ein synchroner Datenaustausch des Netzwerkteilnehmers mit anderen Netzwerkteilnehmern im Automatisierungskommunikationsnetzwerk ermöglicht werden.

Das Generieren der Zeit der internen Uhr beruht auf der Taktfrequenz des Datenaustauschs im Automatisierungskommunikationsnetzwerk. Vorteilhafterweise muss die generierte Zeit der internen Uhr dadurch nicht in eine Taktdomäne des Datenaustauschs transformiert werden. Eine solche Transformation ist nicht verzögerungsfrei, und die Verzögerung ist insbesondere nicht konstant, so dass sie nicht statisch eingerechnet werden kann. Eine beim Datenaustausch durch die Verzögerung verursachte Abweichung der von der internen Uhr bereitgestellten Zeit von einer Systemzeit einer Referenzuhr wird auch als Jitter bezeichnet. Ein Jitter kann dazu führen, dass ein im Rahmen des Datenaustauschs ausgetauschtes Datagramm mit einem inkorrekten Zeitstempel versehen wird. Die Verzögerung durch die Transformation von einer Taktdomäne der internen Uhr in die Taktdomäne des Datenaustauschs im Automatisierungskommunikationsnetzwerk entfällt vorteilhafterweise beim Verfahren. Dadurch können im Automatisierungskommunikationsnetzwerk ausgetauschten Datagrammen akkurate Zeitstempel zugeordnet werden.

In einer Ausführungsform ist die Sequenz von ganzzahligen Inkrementen eine alternierende Sequenz eines ersten Inkrements und eines zweiten Inkrements. Das erste Inkrement ist die größte ganze Zahl, die kleiner als die Periodendauer ist. Das zweite Inkrement ist die kleinste ganze Zahl, die größer als die Periodendauer ist. Vorteilhafterweise sind Abweichungen des Zählwerts der internen Uhr, wobei der Zählwert als ganze Zahl dargestellt wird, von einem idealen Zählwert für die alternierende Sequenz nach jedem Inkrementierungsschritt bzw. nach jedem Takt auf Rundungsfehler beschränkt.

In einer Ausführungsform des Verfahrens ist eine Reihenfolge der Inkremente derart festgelegt, dass nach jedem Takt eine Abweichung einer Summe von Inkrementen von bereits erfolgten Takten von einem Vielfachen der Periodendauer minimal ist. Abweichungen des Zählwerts der internen Uhr von einem Vielfachen der Periodendauer können den Datenaustausch im Automatisierungskommunikationsnetzwerk beeinflussen. Beispielsweise werden Empfangszeiten von Datagrammen mit Zeiten von internen Uhren versehen. Auch müssen verschiedene Netzwerkteilnehmer Signale zu festgelegten Zeiten ausgeben. Eine Abweichung des Zählwerts der internen Uhr von einem Vielfachen der Periodendauer kann aus diesen Gründen einen synchronen Datenaustausch im Automatisierungskommunikationsnetzwerk negativ beeinflussen. Vorteilhafterweise kann ein solcher Einfluss durch eine festgelegte Reihenfolge der Inkremente der Sequenz von Inkrementen minimiert werden.

In einer Ausführungsform wird eine Drift der internen Uhr des Netzwerkteilnehmers im Vergleich zu einer Referenzuhr des Automatisierungskommunikationsnetzwerks durch Anpassen zumindest eines Inkrements der Sequenz der Inkremente berücksichtigt. Vorteilhafterweise wird ein synchroner Datenaustausch gewahrt, wenn eine Drift der internen Uhr berücksichtigt und kompensiert wird.

In einer Ausführungsform wird das Inkrementieren der internen Uhr mittels der Sequenz der ganzzahligen Inkremente wiederholt. Dadurch bleibt die Synchronität des Datenaustauschs vorteilhafterweise erhalten.

Ein Netzwerkteilnehmer ist dazu vorgesehen, Daten mit weiteren Netzwerkteilnehmern in einem Automatisierungskommunikationsnetzwerk mit einer festgelegten Taktfrequenz auszutauschen. Der Netzwerkteilnehmer weist eine interne Uhr zum Synchronisieren des Datenaustauschs mit zumindest einem weiteren Netzwerkteilnehmer auf. Die interne Uhr ist dazu vorgesehen, eine Zeit in als ganzzahligen Zählwert bereitzustellen. Die Taktfrequenz ist derart festgelegt, dass eine Periodendauer pro Takt von der internen Uhr nicht durch einen ganzzahligen Zählwert darstellbar ist. Der Netzwerkteilnehmer weist eine interne Steuereinheit auf. Die interne Steuereinheit ist dazu ausgebildet, die interne Uhr mittels einer festgelegten Sequenz von ganzzahligen Inkrementen zu inkrementieren. Die Sequenz der ganzzahligen Inkremente ist derart festgelegt, dass eine Summe der ganzzahligen Inkremente einem ganzzahligen Vielfachen der Periodendauer entspricht.

Ein Automatisierungskommunikationsnetzwerk weist zumindest zwei Netzwerkteilnehmer auf. Die Netzwerkteilnehmer sind zum Austauschen von Daten über einen Feldbus miteinander verbunden. Zusätzlich weist das Automatisierungskommunikationsnetzwerk eine mit den Netzwerkteilnehmern verbundene Steuereinheit des Automatisierungskommunikationsnetzwerks auf.

Die oben beschriebenen Eigenschaften, Merkmale und Vorteile dieser Erfindung sowie die Art und Weise, wie diese erreicht werden, sind klarer und deutlicher verständlich im Zusammenhang mit der folgenden Beschreibung der Ausführungsbeispiele, die im Zusammenhang mit den Zeichnungen näher erläutert werden. Dabei zeigen in jeweils schematischer Darstellung:
Fig. 1 ein beispielhaftes Automatisierungskommunikationsnetzwerk;
Fig. 2 ein Regelungsprinzip zum Regeln einer internen Uhr eines zu synchronisierenden Netzwerkteilnehmers im Automatisierungskommunikationsnetzwerk; und
Fig. 3 eine Tabelle, die unterschiedliche Möglichkeiten eine interne Uhr eines Netzwerkteilnehmers mittels einer Sequenz von ganzzahligen Inkrementen zu inkrementieren zeigt.

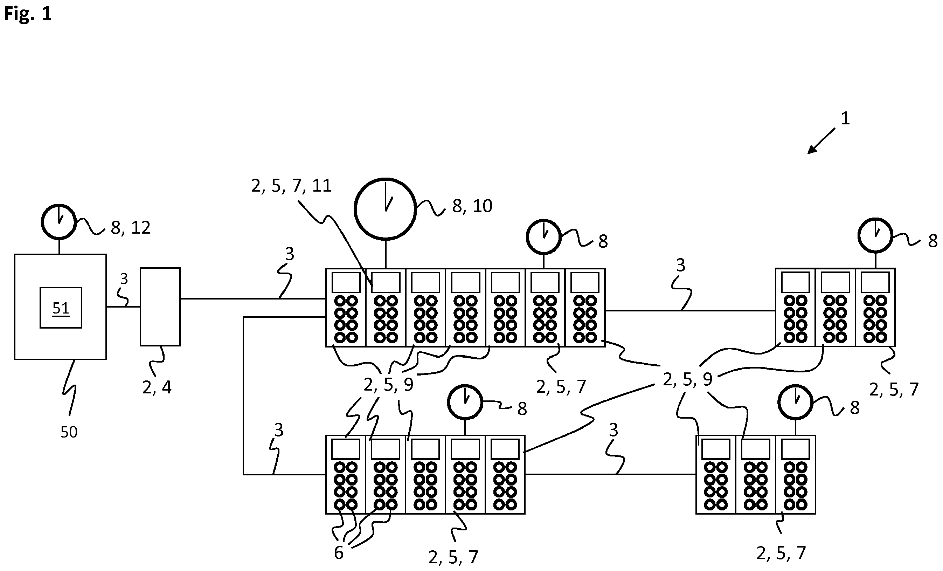

Fig. 1 zeigt schematisch ein Automatisierungskommunikationsnetzwerk 1.

Das Automatisierungskommunikationsnetzwerk 1 weist eine Mehrzahl von Netzwerkteilnehmern 2 und eine Steuereinheit 50 auf. Beispielhaft weist das Automatisierungskommunikationsnetzwerk 1 neunzehn Netzwerkteilnehmer 2 auf. Das Automatisierungskommunikationsnetzwerk 1 kann jedoch eine andere Anzahl von Netzwerkteilnehmern 2 aufweisen. Eine Topologie des Automatisierungskommunikationsnetzwerks 1 kann von der in Fig. 1 beispielhaft gezeigten Topologie abweichen. Die Steuereinheit 50 weist einen Master 51 auf, der beispielsweise als Software ausgebildet ist und zumindest eine Kommunikation, sprich einen Datenaustausch zwischen den Netzwerkteilnehmern 2 und der Steuereinheit 50 auf einem Feldbus 3 steuern kann. Das Automatisierungskommunikationsnetzwerk 1 weist einen übergeordneten Netzwerkteilnehmer 4 auf. Der übergeordnete Netzwerkteilnehmer 4 kann auch als Buskoppler bezeichnet werden. Ferner weist das Automatisierungskommunikationsnetzwerk 1 dem übergeordneten Netzwerkteilnehmer 4 untergeordnete Netzwerkteilnehmer 5 auf.

Die Steuereinheit 50 ist mit dem übergeordneten Netzwerkteilnehmer 4 über den Feldbus 3 verbunden. Die Netzwerkteilnehmer 2 sind ebenfalls über den Feldbus 3 miteinander verbunden. Über den Feldbus 3 können die Netzwerkteilnehmer 2 und die Steuereinheit 50 Daten miteinander austauschen. Beispielsweise können die Netzwerkteilnehmer 2 und die Steuereinheit 50 dazu ausgebildet sein, Daten auszutauschen, die auf dem EtherCAT Protokoll basieren. Entsprechend ist der Master 51 ausgebildet, Datagramme entsprechend des EtherCAT-Protokolls zu versenden bzw. zu empfangen. Die untergeordneten Netzwerkteilnehmer 5 weisen jeweils eine Anschalteinheit zum Verarbeiten von ausgetauschten Daten auf. Die Anschalteinheiten können auch als Slaves bezeichnet werden. Die Anschalteinheiten können beispielsweise als anwendungsspezifische integrierte Schaltungen (application-specific integrated circuit, ASIC) oder beispielsweise als im Feld programmierbare Gatter Anordnungen (Field Programmable Gate Array, FPGA) ausgebildet sein. Die Anschalteinheiten der untergeordneten Netzwerkteilnehmer 5 sind in Fig. 1 nicht dargestellt.

Die untergeordneten Netzwerkteilnehmer 5 sind als Eingabe-/ Ausgabeeinheiten mit Anschlüssen 6 für Feldgeräte ausgebildet. Bei den Feldgeräten kann es sich beispielsweise um Sensoren und Aktoren handeln. Feldgeräte, die an das Automatisierungskommunikationsnetzwerk 1 angebunden sind, sind in Fig. 1 nicht dargestellt.

Die untergeordneten Netzwerkteilnehmer 5 weisen ferner jeweils eine interne Steuereinheit auf. Die internen Steuereinheiten sind in Fig. 1 nicht dargestellt. Die internen Steuereinheiten sind mit den Anschalteinheiten jeweils über eine Datenleitung verbunden. Die internen Steuereinheiten sind dazu ausgebildet, auf Grundlage von von den Anschalteinheiten verarbeiteten Daten die Feldgeräte anzusteuern.

Das Automatisierungskommunikationsnetzwerk 1 weist hinsichtlich des Datenaustauschs miteinander zu synchronisierende Netzwerkteilnehmer 7 auf. Beispielhaft weist das Automatisierungskommunikationsnetzwerk 1 der Fig. 1 fünf miteinander zu synchronisierende Netzwerkteilnehmer 7 auf. Das Automatisierungskommunikationsnetzwerk 1 kann jedoch auch eine andere Anzahl von miteinander zu synchronisierenden Netzwerkteilnehmern 7 aufweisen. Das Automatisierungskommunikationsnetzwerk 1 weist zumindest zwei miteinander zu synchronisierende Netzwerkteilnehmer 7 auf. Zum Zweck des Synchronisierens des Datenaustauschs weisen die zu synchronisierenden Netzwerkteilnehmer 7 jeweils eine interne Uhr 8 auf. Nicht miteinander zu synchronisierende Netzwerkteilnehmer 9 weisen jeweils keine interne Uhr 8 auf. Eine Anordnung der zu synchronisierenden Netzwerkteilnehmer 7 und der nicht zu synchronisierenden Netzwerkteilnehmer 9 im Automatisierungskommunikationsnetzwerk 1 kann von der Darstellung der Fig. 1 abweichen.

Die internen Uhren 8 der zu synchronisierenden Netzwerkteilnehmer 7 sind Bestandteil der Anschalteinheiten. Die internen Uhren 8 können beispielsweise als Schwingquarze ausgebildet sein. Die internen Uhren 8 sind jeweils als inkrementierende Zähler ausgebildet. Die internen Uhren 8 sind dazu vorgesehen, eine Zeit als ganzzahligen Zählwert bereitzustellen. Die internen Uhren 8 bilden ein System verteilter Uhren (distributed clocks) im Automatisierungskommunikationsnetzwerk 1.

Als Referenzuhr 10 dient die interne Uhr 8 einer Anschalteinheit, die im Automatisierungskommunikationsnetzwerks 1 als erster Slave mit einer internen Uhr 8 nach dem Master 51 angeordnet ist. Dies ist in Fig. 1 dadurch angedeutet, dass die interne Uhr 8 eines ersten untergeordneten Netzwerkteilnehmers 11 als größte Uhr dargestellt ist. Die Referenzuhr 10 kann beispielsweise an eine globale Uhr, beispielsweise an eine nach im IEEE 1588 Standard definierte Uhr (grandmaster clock), angepasst sein. Die Referenzuhr 10 ist dazu vorgesehen eine Systemzeit bereitzustellen. Die Referenzuhr 10 ist zur Synchronisation der Netzwerkteilnehmer 7 auf kurzen Zeitskalen, beispielsweise auf einer Sub-Millisekunden Zeitskala, vorgesehen. Dadurch betrifft die Synchronisation der Netzwerkteilnehmer 7 anhand der Referenzuhr 10 insbesondere eine Echtzeitsynchronisation.

Als eine absolute globale Zeitreferenz dient die interne Uhr 8 der Steuereinheit 50, die Bestandteil des Masters 51 ist und als Masteruhr 12 bezeichnet werden soll. Die Masteruhr 12 kann beispielsweise auf einem globalen Zeitformat, beispielsweise auf dem Zeitformat des Zeitzeichensenders DCF77, oder beispielsweise auf einer innerhalb des Automatisierungskommunikationsnetzwerks 1 geltenden Zeit, beispielsweise bereitgestellt von einer BIOS-Uhr, beruhen. Der Master 51 ist dazu ausgebildet, die Referenzuhr 10 zu initialisieren, die Systemzeit unter Verwendung der Masteruhr 12 bereitzustellen und den gesamten Datenaustausch im Automatisierungskommunikationsnetzwerk 1 zu synchronisieren. Da die sich nach der Referenzuhr 10 richtende Echtzeitsynchronisation der Netzwerkteilnehmer 7 und die sich nach der Masteruhr 12 richtende Synchronisation des gesamten Datenaustauschs des Automatisierungskommunikationsnetzwerks 1 auf verschiedenen Zeitskalen erfolgen, verletzt die Masteruhr 12 eine übergeordnete Stellung der Referenzuhr 10 des Automatisierungskommunikationsnetzwerks 1 nicht.

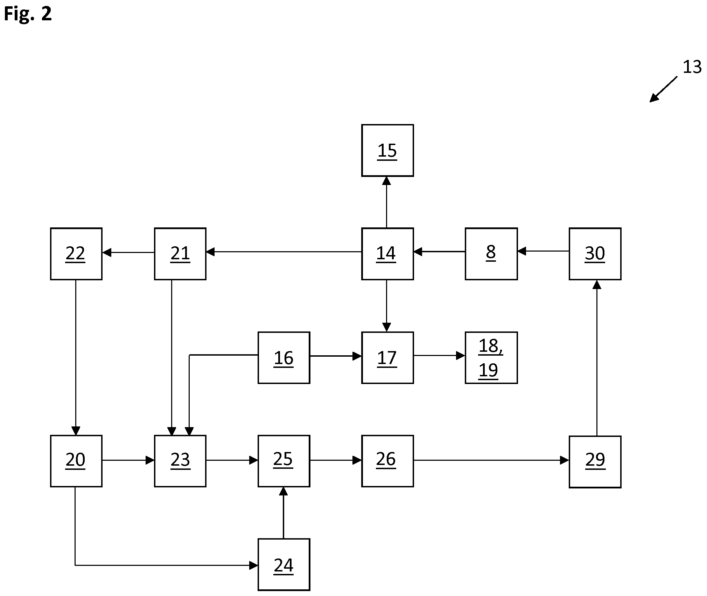

Fig. 2 zeigt schematisch ein Regelungsprinzip 13 zum Regeln einer internen Uhr 8 eines zu synchronisierenden Netzwerkteilnehmers 7 im Automatisierungskommunikationsnetzwerk 1. Die interne Uhr 8 ist als inkrementierender Zähler ausgebildet und dazu vorgesehen, eine lokale Zeit 14 des zu synchronisierenden Netzwerkteilnehmers 7 als ganzzahligen Zählwert bereitzustellen.

Die lokale Zeit 14 kann einem Synchronisationsmanager (Sync-Manager) 15 des Slaves bereitgestellt werden. Der Synchronisationsmanager 15 ist für einen konsistenten und sicheren Datenaustausch zwischen dem Master 51 und der mit dem Slave verbundenen internen Steuereinheit vorgesehen.

Der Master 51 kann ein Datagramm an die Slaves übermitteln. Der erste Slave des ersten untergeordneten Netzwerkteilnehmers 11 kann seine auf der Referenzuhr 10 beruhende Systemzeit im Datagramm hinterlegen. Dann kann das Datagramm vom ersten Slave an weitere Slaves im Automatisierungskommunikationsnetzwerk 1 weitergeleitet werden. Auf diese Weise können alle Slaves und der Master eine Kopie der Systemzeit erhalten.

Die internen Uhren 8 des Automatisierungskommunikationsnetzwerks 1 sind unabhängig voneinander ausgebildet. Dadurch, dass die internen Uhren 8 jeweils zu unterschiedlichen Zeiten aktiviert werden können, können die internen Uhren 8 jeweils untereinander einen zeitlichen Versatz aufweisen. Insbesondere können die internen Uhren 8 einen zeitlichen Versatz 16 im Vergleich zur Referenzuhr 10 aufweisen. Der zeitliche Versatz 16 zur Referenzuhr 10 kann für jede interne Uhr 8 lokal im jeweiligen Slave kompensiert werden. Um eine einheitliche Systemzeit im gesamten Automatisierungskommunikationsnetzwerk 1 bereitstellen zu können, kann der zeitliche Versatz 16 der internen Uhren 8 zur Systemzeit vom Master 51 für jede interne Uhr 8 ermittelt und jeweils in einem Register eines Slaves hinterlegt werden. Dadurch kann jedem Slave eine lokale Kopie 17 der Systemzeit bereitgestellt werden.

Die lokalen Kopien 17 der Systemzeit können für SyncSignale 18 oder für LatchSignale 19 verwendet werden. SyncSignale 18 und LatchSignale 19 sind Signale, die einer Synchronisation lokaler Anwendungen mit dem Datenaustausch des Automatisierungskommunikationsnetzwerk 1 dienen können. SyncSignale 18 werden von einem Slave ausgegeben. Ein SyncSignal 18 kann beispiesweise eine Unterbrechungsanforderung (interrupt) sein. LatchSignale 19 werden an einen Slave übermittelt. SyncSignale 18 können auf Basis der lokalen Kopien 17 der Systemzeit zu definierten Zeitpunkten von den Slaves ausgegeben werden. An die Slaves übermittelte LatchSignale 19 können mit definierten Zeitstempeln versehen werden (time stamping).

Da Datagramme, die vom Master 51 an die Slaves übermittelt werden, in den Slaves verarbeitet und an andere Slaves weitergeleitet werden müssen, kann es sein, dass eine Laufzeitverzögerung 20 beim Übermitteln eines Datagramms auftritt. Dies kann auch durch endliche Kabellängen zwischen den Slaves hervorgerufen werden. Zum Synchronisieren der Netzwerkteilnehmer 7 muss die Laufzeitverzögerung zwischen der Referenzuhr 10 und einer internen Uhr 8 berücksichtigt werden. Um den Effekt der Laufzeitverzögerung zu kompensieren, kann der Master 51 ein Datagramm aussenden, dessen Empfangszeiten von jedem Slave auf Basis der jeweiligen lokalen Zeit 14 gespeichert werden. Diese lokalen Empfangszeiten 21 werden jeweils in einem Register 22 eines Slaves hinterlegt. Bei den lokalen Empfangszeiten 21 kann es sich beispielsweise um Zeiten handeln, zu denen ein Datenfeld des Datagramms an Anschlüssen der Slaves oder an Verarbeitungseinrichtungen der Slaves empfangen wird. Das Datenfeld kann beispielsweise ein sogenanntes Start-of-Frame Datenfeld sein, dass an eine Präambel des Datagramms anschließt. Der Master 51 kann auf die lokalen Empfangszeiten 21 zugreifen und daraus eine Laufzeitverzögerung 20 für jeden Slave ermitteln. Eine lokale Empfangszeit 21 kann also mittels der Laufzeitverzögerung 20 korrigiert werden. Unter zusätzlicher Berücksichtigung des zeitlichen Versatzes 16 resultiert eine verzögerungskorrigierte Empfangszeit 23 auf Basis der lokalen Kopie 17 der Systemzeit.

Ein weiterer Effekt, der zu Abweichungen zwischen einer internen Uhr 8 und der Referenzuhr 10 führen kann, ist eine Drift, die durch unterschiedliche Uhrengeschwindigkeiten hervorgerufen werden kann. Wenn eine interne Uhr 8, die als inkrementierender Zähler die lokale Zeit 14 in einer Ganzzahldarstellung angibt, beispielsweise in einem Takt mit einer Periodendauer von 10ns ihren Zählwert der lokalen Zeit 14 um den Wert "10" erhöht, die Referenzuhr 10 jedoch pro Takt um 9ns fortschreitet, so ist die interne Uhr 8 schneller als die Referenzuhr 10.

Um den Effekt der Drift zu kompensieren, kann der Master 51 Systemzeiten an die Slaves in periodischen Abständen übermitteln. Die übermittelten Systemzeiten 24, bei denen auch eine Laufzeitverzögerung 20 berücksichtigt werden kann, und die verzögerungskorrigierte Empfangszeit 23 auf Basis der lokalen Kopie 17 der Systemzeit werden einer Vergleichseinrichtung 25 bereitgestellt. Die Vergleichseinrichtung 25 kann auch als Systemzeit-Differenzfilter bezeichnet werden. Die Vergleichseinrichtung 25 ist dazu ausgebildet, eine mittlere Systemzeitdifferenz 26 zwischen den periodisch übermittelten Systemzeiten 24 und der verzögerungskorrigierten Empfangszeit 23 auf Basis der lokalen Kopie 17 der Systemzeit zu ermitteln. Ist die mittlere Systemzeitdifferenz 26 positiv, ist die interne Uhr 8 schneller als die Referenzuhr 10. Umgekehrt ist die interne Uhr 8 langsamer als die Referenzuhr 10, wenn die mittlere Systemzeitdifferenz 26 negativ ist.

Auf Basis der mittleren Systemzeitdifferenz 26 wird anschließend eine Geschwindigkeitsdifferenz 29 zwischen der internen Uhr 8 und der Referenzuhr 10 ermittelt, geglättet und zum Kompensieren der Drift der internen Uhr 8 bereitgestellt.

Wenn eine interne Uhr 8 beispielsweise in einem Takt mit einer Periodendauer von 10ns ihren Zählwert der lokalen Zeit 14 um den Wert "10" erhöht, eine Taktperiode der Referenzuhr 10 jedoch von der Periodendauer von 10ns abweicht, kann diese Abweichung über mehrere Takte hinweg zunehmen. Die Geschwindigkeitsdifferenz 29 wird einer Regelungseinrichtung 30 bereitgestellt. Die Regelungseinrichtung 30 kann die interne Uhr 8 auf Basis der Geschwindigkeitsdifferenz 29 an die Referenzuhr 10 anpassen. Das Anpassen kann dadurch erfolgen, dass der Zählwert der internen Uhr 8 gelegentlich um den Wert "9" oder um den Wert "11" erhöht wird.

In einem Betrieb des Automatisierungskommunikationsnetzwerks 1 tauschen alle Netzwerkteilnehmer 2 Daten mit einer festgelegten Taktfrequenz aus. Die Taktfrequenz kann beispielsweise 100MHz betragen. Das System der verteilten internen Uhren 8 des Automatisierungskommunikationsnetzwerks 1 kann ebenfalls mit einer 100MHz-Logik betrieben werden. Eine Periodendauer pro Takt beträgt bei 100MHz 10ns. Es ist in diesem Fall zweckmäßig, dass eine interne Uhr 8 ihren Zählwert der lokalen Zeit 14 in einem Takt mit einer Periodendauer von 10ns um den Wert "10" erhöht. Eine Zeitauflösung beträgt in diesem Fall 1ns. Unter diesen Bedingungen werden beispielsweise Datagramme mit einer Bitbreite von 1Bit mit einer Verarbeitungsrate von 100Mbit/s verarbeitet. Bei einer Kompensation der Drift kann der Zählwert der lokalen Zeit 14 im Takt mit der Periodendauer von 10ns statt um den Wert "10" gelegentlich beispielsweise um dem Wert "9" oder dem Wert "11" erhöht werden.

Es kann festgelegt sein, dass die Verarbeitungsrate 1000Mbit/s betragen soll. In diesem Fall bietet es sich an, Datagramme mit einer Breite von 1Byte (8Bit) mit einer Taktfrequenz von 125MHz zu verarbeiten. Die Periodendauer pro Takt beträgt 8ns. Wenn das System der verteilten internen Uhren 8 an diesen Takt angepasst werden soll, so können die internen Uhren 8 ihre Zählwerte der lokalen Zeiten 14 in einem Takt mit einer Periodendauer von 8ns um den Wert "8" erhöhen. Bei einer Kompensation der Drift kann der Zählwert der lokalen Zeit 14 im Takt mit der Periodendauer von 8ns statt um den Wert "8" gelegentlich beispielsweise um den Wert "7" oder um den Wert "9" erhöht werden.

In der nachfolgenden Beschreibung wird ein Verfahren zum Betreiben eines zu synchronisierenden Netzwerkteilnehmers 7 im Automatisierungskommunikationsnetzwerk 1 beschrieben. Das Verfahren ist dazu vorgesehen, einen Datenaustausch des zu synchronisierenden Netzwerkteilnehmers 7 im Betrieb des Automatisierungskommunikationsnetzwerks 1 mit zumindest einem weiteren Netzwerkteilnehmer 7 zu synchronisieren. Alle Netzwerkteilnehmer 2 des Automatisierungskommunikationsnetzwerks 1 sollen Daten bei einer Taktfrequenz austauschen, die derart festgelegt ist, dass die Periodendauer pro Takt von der internen Uhr 8 nicht durch einen ganzzahligen Zählwert darstellbar ist.

Beispielsweise können für eine Verarbeitungsrate von 10.000Mbit/s beispielsweise 64Bit breite Datagramme bei einer Taktfrequenz von 156,25MHz verarbeitet werden. Eine Periodendauer pro Takt beträgt in diesem Fall 6,4ns. Da die internen Uhren 8 dazu vorgesehen sind, lokale Zeiten 14 als ganzzahlige Zählwerte bereitzustellen, ist dies für die Periodendauer von 6,4ns nicht möglich. Das Register 22 eines Slaves, in dem beispielsweise lokale Empfangszeitenzeiten 21 hinterlegt werden, kann ebenfalls nur ganzzahlige Werte enthalten.

Grundsätzlich ist es zwar möglich, dass die lokalen Zeiten 14 mittels einer anderen Taktdomäne als einer Taktdomäne der Datenverarbeitung generiert werden. Allerdings ist das System der verteilten internen Uhren 8 an die Datenverarbeitung gekoppelt. Beispielsweise werden dem Datagramm beim Ermitteln der Laufzeitverzögerung 20 lokale Empfangszeitenzeiten 21 zugeordnet. Wenn Datagramme im Automatisierungskommunikationsnetzwerk 1 mit einer festgelegten Taktfrequenz verarbeitet werden, das System der verteilten internen Uhren 8 jedoch in einer anderen Taktdomäne betrieben wird, müssen die lokalen Zeiten 14 aus ihrer Taktdomäne in die Taktdomäne der Datenverarbeitung transformiert werden. Diese Transformation ist allerdings nicht verzögerungsfrei und kann beim Datenaustausch zu zusätzlichen Abweichungen der lokalen Zeiten 14 von der Systemzeit führen. Dadurch kann es sein, dass im Rahmen der Transformation die Empfangszeit eines Datagramms einen erhöhten Fehler aufweist. Aus diesem Grund soll beim Verfahren zum Betreiben eines zu synchronisierenden Netzwerkteilnehmers 7 die lokale Zeit 14 des zu synchronisierenden Netzwerkteilnehmers 7 anhand der Taktfrequenz der Datenverarbeitung generiert werden.

Das Verfahren umfasst einen Verfahrensschritt, im Rahmen dessen die interne Uhr 8 des zu synchronisierenden Netzwerkteilnehmers 7 mittels einer festgelegten Sequenz von ganzzahligen Inkrementen inkrementiert wird. Die Sequenz der ganzzahligen Inkremente ist derart festgelegt, dass eine Summe der ganzzahligen Inkremente der Sequenz der Inkremente einem ganzzahligen Vielfachen der Periodendauer entspricht, wobei die Periodendauer pro Takt von der internen Uhr 8 nicht durch einen ganzzahligen Zählwert darstellbar ist. Das Verfahren beruht also darauf, dass die Sequenz der ganzzahligen Inkremente derart festgelegt ist, dass eine Abweichung des Zählwerts der internen Uhr 8 von einem idealen Zählwert der internen Uhr 8 nach dem Inkrementieren der internen Uhr 8 mittels der Sequenz der Inkremente ausgeglichen wird. Der ideale Zählwert entspricht einem Produkt aus einer Anzahl der Takte bzw. einer Anzahl der Inkremente der Sequenz von Inkrementen und der nicht durch einen ganzzahligen Zählwert darstellbaren Periodendauer, die als ideales Inkrement bezeichnet werden soll.

Für das Beispiel der 156,25MHz-Logik kann beispielsweise eine Sequenz der Inkremente "6" und "7" gewählt werden. Beispielsweise liefert die Sequenz der Inkremente (6, 6, 6, 7, 7) eine Summe der Inkremente mit einem Wert von "32". Dies entspricht einem fünffachen des idealen Inkrements mit einem Wert von "6,4". Nach dem Inkrementieren der internen Uhr 8 mittels der Sequenz (6, 6, 6, 7, 7) weist der Zählwert der internen Uhr 8 also keine Abweichung zum idealen Zählwert "32" auf.

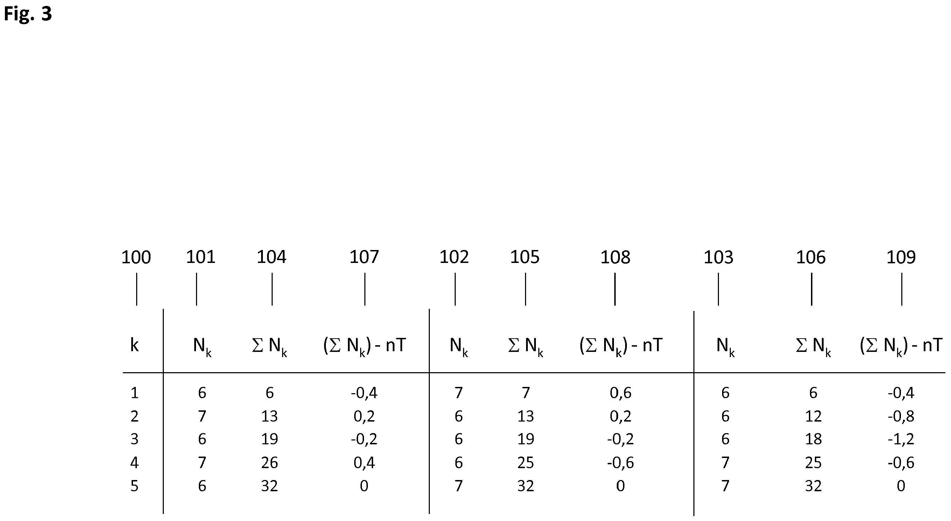

In Fig. 3 ist eine Tabelle dargestellt, die unterschiedliche Möglichkeiten zeigt, eine interne Uhr 8 eines zu synchronisierenden Netzwerkteilnehmers 7 mittels einer Sequenz von ganzzahligen Inkrementen zu inkrementieren. Beispielhaft soll das ideale Inkrement pro Takt "6,4" betragen.

Die Tabelle der Fig. 3 zeigt eine Spalte 100, in welcher Nummern der Takte bzw. Nummern der Inkremente der Sequenz von Inkrementen "k" eingetragen sind. In einer ersten Spalte 101 ist eine erste Sequenz von Inkrementen "Nₖ" eingetragen. In einer zweiten Spalte 102 ist eine zweite Sequenz von Inkrementen "Nₖ" eingetragen. In einer dritten Spalte 103 ist eine dritte Sequenz von Inkrementen "Nₖ" eingetragen. Die erste, die zweite und die dritte Sequenz von Inkrementen unterscheiden sich hinsichtlich einer Reihenfolge der ganzzahligen Inkremente "6" und "7". Die erste Sequenz von Inkrementen lautet (6, 7, 6, 7, 6). Die zweite Sequenz von Inkrementen lautet (7, 6, 6, 6, 7). Die dritte Sequenz von Inkrementen lautet (6, 6, 6, 7, 7).

In einer vierten Spalte 104 sind Summen "∑ Nₖ" über die Inkremente der ersten Sequenz eingetragen. Beispielsweise ist nach dem dritten Takt (k=3) ∑ Nₖ = N₁ + N₂ + N₃. Nach dem fünften Takt (k=5) ist ∑ Nₖ = N₁ + N₂ + N₃ + N₄ + N₅. Analog sind in einer fünften Spalte 105 und in einer sechsten Spalte 106 jeweils Summen "∑ Nₖ" über die Inkremente der zweiten Sequenz bzw. der dritten Sequenz eingetragen. Die Summen über die Inkremente der ganzzahligen Inkremente der jeweiligen Sequenz von Inkrementen betragen jeweils nach dem fünften Takt (k = 5) "32". Die jeweiligen Summen der Inkremente sind identisch und entsprechen einem ganzzahligen Vielfachen des idealen Inkrements "6,4".

In einer siebten Spalte 107 sind Abweichungen "(∑ Nₖ) - nT" des Zählwerts einer internen Uhr 8 nach einem Takt vom idealen Zählwert für die erste Sequenz von Inkrementen eingetragen. "T" entspricht dabei der Periodendauer bzw. dem idealen Inkrement. "n" bezeichnet einen Endwert der Summen für den Takt "k". Analog sind in einer achten Spalte 108 und in einer neunten Spalte 109 Abweichungen "(∑ Nₖ) - nT" der Zählwerte von internen Uhren 8 nach einem Takt vom idealen Zählwert für die zweite bzw. die dritte Sequenz von Inkrementen eingetragen.

Anhand der Abweichungen "(∑ Nₖ) - nT" ist zu erkennen, dass die Reihenfolge der Inkremente "6" und "7" einen Einfluss auf die Abweichungen hat. Beispielsweise weist die dritte Sequenz der Inkremente (6, 6, 6, 7, 7) eine maximale Abweichung von "-1,2" nach dem dritten Takt auf. Bei der zweiten Sequenz der Inkremente (7, 6, 6, 6, 7) beträgt eine maximale Abweichung "+0,6" nach dem ersten Takt bzw. "-0,6" nach dem vierten Takt. Durch eine Verwendung der zweiten Sequenz von Inkrementen statt der dritten Sequenz von Inkrementen zum Inkrementieren einer internen Uhr 8, d. h. durch Anpassen der Reihenfolge der Sequenz von Inkrementen, kann beim Verfahren zum Betreiben eines zu synchronisierenden Netzwerkteilnehmers 7 eine maximale Abweichung reduziert werden.

Die erste Sequenz von Inkrementen (6, 7, 6, 7, 6) ist eine alternierende Sequenz der Inkremente "6" und "7". Eine maximale Abweichung beträgt in diesem Fall "-0,4" nach dem ersten Takt bzw. "+0,4" nach dem vierten Takt. Durch eine Verwendung der ersten Sequenz von Inkrementen statt der zweiten Sequenz von Inkrementen zum Inkrementieren einer internen Uhr 8 kann beim Verfahren zum Betreiben eines zu synchronisierenden Netzwerkteilnehmers 7 also eine maximale Abweichung weiter reduziert werden. Die erste Sequenz von Inkrementen stellt eine Sequenz dar, für die die maximale Abweichung minimiert worden ist.

Allgemein kann beim Verfahren also eine Sequenz von ganzzahligen Inkrementen gewählt werden, die eine alternierende Sequenz eines ersten Inkrements und eines zweiten Inkrements ist. Das erste Inkrement ist die größte ganze Zahl, die kleiner als die Periodendauer bzw. als das ideale Inkrement ist. Das zweite Inkrement ist die kleinste ganze Zahl, die größer als die Periodendauer bzw. als das ideale Inkrement ist.

Bei der ersten Sequenz von Inkrementen stellt das Inkrement "6" das erste Inkrement dar. Das Inkrement "7" stellt das zweite Inkrement dar. Ob die alternierende Sequenz mit dem ersten Inkrement oder mit dem zweiten Inkrement begonnen werden sollte, hängt vom idealen Inkrement ab. Bei einem idealen Inkrement von "6,4" ist es zweckmäßig die alternierende Sequenz mit dem ersten Inkrement zu beginnen, da eine Abweichung des ersten Inkrements vom idealen Inkrement in diesem Fall kleiner ist, als eine Abweichung des zweiten Inkrements vom idealen Inkrement. Beträgt das ideale Inkrement beispielsweise "6,6", ist es zweckmäßig, die alternierende Sequenz mit dem zweiten Inkrement zu beginnen.

Allgemein kann beim Verfahren also eine Sequenz von ganzzahligen Inkrementen gewählt werden, deren Reihenfolge derart festgelegt ist, dass nach jedem Takt eine Abweichung einer Summe von Inkrementen von bereits erfolgten Takten von einem Vielfachen der Periodendauer minimal ist. Dies ist beispielsweise für die erste Sequenz von Inkrementen der Fall.

Im Betrieb des Automatisierungskommunikationsnetzwerks 1 bei einer Taktfrequenz, die derart festgelegt ist, dass die Periodendauer pro Takt von einer internen Uhr 8 nicht durch einen ganzzahligen Zählwert darstellbar ist, kann das Verfahren wiederholt werden. Das Inkrementieren einer internen Uhr 8 mittels der Sequenz von ganzzahligen Inkrementen kann also wiederholt werden, um die Synchronität des Netzwerkteilnehmers 7 mit weiteren Netzwerkteilnehmern 7 zu wahren.

Beim Verfahren kann auch eine Drift der internen Uhr 8 des zu synchronisierenden Netzwerkteilnehmers 7 im Vergleich zur Referenzuhr 10 des Automatisierungskommunikationsnetzwerks 1 durch Anpassen zumindest eines Inkrements der Sequenz der Inkremente berücksichtigt werden. Dabei sollte die Kompensation der Drift möglichst zu einem Zeitpunkt erfolgen, an dem die Drift festgestellt wurde, da sich ansonsten die mit der Drift einhergehende Abweichung mit zunehmender Anzahl von Takten akkumuliert.

Auch das Inkrementieren der internen Uhr 8 mittels der angepassten Sequenz der ganzzahligen Inkremente kann wiederholt werden, um eine Synchronität des Netzwerkteilnehmers 7 mit weiteren Netzwerkteilnehmern 7 zu wahren.

## Patentansprüche

1. Verfahren zum Betreiben eines Netzwerkteilnehmers (7) in einem Automatisierungskommunikationsnetzwerk (1),
wobei der Netzwerkteilnehmer (7) dazu vorgesehen ist, Daten mit weiteren Netzwerkteilnehmern (2) im Automatisierungskommunikationsnetzwerk (1) mit einer festgelegten Taktfrequenz auszutauschen,
wobei der Netzwerkteilnehmer (7) eine interne Uhr (8) zum Synchronisieren des Datenaustauschs mit zumindest einem weiteren Netzwerkteilnehmer (7) aufweist,
wobei die interne Uhr (8) dazu vorgesehen ist, eine Zeit als ganzzahligen Zählwert bereitzustellen,
wobei die Taktfrequenz derart festgelegt ist, dass eine Periodendauer pro Takt von der internen Uhr (8) nicht durch einen ganzzahligen Zählwert darstellbar ist, wobei das Verfahren folgenden Verfahrensschritt umfasst:
- Inkrementieren der internen Uhr (8) mittels einer festgelegten Sequenz von ganzzahligen Inkrementen,
wobei die Sequenz der ganzzahligen Inkremente derart festgelegt ist, dass eine Summe der ganzzahligen Inkremente einem ganzzahligen Vielfachen der Periodendauer entspricht.

2. Verfahren gemäß Anspruch 1,
wobei die Sequenz von ganzzahligen Inkrementen eine alternierende Sequenz eines ersten Inkrements und eines zweiten Inkrements ist,
wobei das erste Inkrement die größte ganze Zahl, die kleiner als die Periodendauer ist, ist,
wobei das zweite Inkrement die kleinste ganze Zahl, die größer als die Periodendauer ist, ist.

3. Verfahren gemäß Anspruch 1 oder 2,
wobei eine Reihenfolge der Inkremente derart festgelegt ist, dass nach jedem Takt eine Abweichung einer Summe von Inkrementen von bereits erfolgten Takten von einem Vielfachen der Periodendauer minimal ist.

4. Verfahren gemäß einem der vorhergehenden Ansprüche, wobei eine Drift der internen Uhr (8) des Netzwerkteilnehmers (7) im Vergleich zu einer Referenzuhr (10) des Automatisierungskommunikationsnetzwerks (1) durch Anpassen zumindest eines Inkrements der Sequenz von Inkrementen berücksichtigt wird.

5. Verfahren gemäß einem der vorhergehenden Ansprüche, wobei das Inkrementieren der internen Uhr (8) mittels der Sequenz von ganzzahligen Inkrementen wiederholt wird.

6. Netzwerkteilnehmer (7),
der dazu vorgesehen ist, Daten mit weiteren Netzwerkteilnehmern (2) in einem Automatisierungskommunikationsnetzwerk (1) mit einer festgelegten Taktfrequenz auszutauschen,
wobei der Netzwerkteilnehmer (7) eine interne Uhr (8) zum Synchronisieren des Datenaustauschs mit zumindest einem weiteren Netzwerkteilnehmer (7) aufweist,
wobei die interne Uhr (8) dazu vorgesehen ist, eine Zeit als ganzzahligen Zählwert bereitzustellen,
wobei die Taktfrequenz derart festgelegt ist, dass eine Periodendauer pro Takt von der internen Uhr (8) nicht durch einen ganzzahligen Zählwert darstellbar ist, wobei der Netzwerkteilnehmer (7) eine interne Steuereinheit aufweist,
wobei die interne Steuereinheit dazu ausgebildet ist, die interne Uhr (8) mittels einer festgelegten Sequenz von ganzzahligen Inkrementen zu inkrementieren,
wobei die Sequenz von ganzzahligen Inkrementen derart festgelegt ist, dass eine Summe der ganzzahligen Inkremente einem ganzzahligen Vielfachen der Periodendauer entspricht.

7. Automatisierungskommunikationsnetzwerk
mit zumindest zwei Netzwerkteilnehmern (7) gemäß Anspruch 6,
wobei die Netzwerkteilnehmer (7) zum Austauschen von Daten über einen Feldbus (3) miteinander verbunden sind, wobei die Netzwerkteilnehmer (7) mit einer Steuereinheit (50) des Automatisierungskommunikationsnetzwerks (1) verbunden sind.

## Claims

1. A method for operating a network subscriber (7) in an automation communication network (1),
wherein the network subscriber (7) is provided for exchanging data with further network subscribers (2) in the automation communication network (1) at a predetermined clock frequency,
wherein the network subscriber (7) comprises an internal clock (8) for synchronizing the data exchange with at least one further network subscriber (7),
wherein the internal clock (8) is embodied to provide a time as an integer count value,
wherein the clock frequency is predetermined in such a way that a period duration per clock pulse cannot be represented as an integer count value by the internal clock (8),
wherein the method comprises the following method step:
- incrementing the internal clock (8) by means of a predetermined sequence of integer increments,
wherein the sequence of integer increments is determined in such a way that a sum of the integer increments corresponds to an integer multiple of the period duration.

2. The method of claim 1,
wherein the sequence of integer increments is an alternating sequence of a first increment and a second increment, wherein the first increment is the largest integer that is less than the period duration,
wherein the second increment is the smallest integer that is larger than the period duration.

3. The method according to claim 1 or 2,
wherein a sequence of the increments is predetermined such that after each clock pulse a deviation of a sum of increments of already occurred clock pulses from a multiple of the period duration is minimal.

4. The method according to any one of the preceding claims, wherein a drift of the internal clock (8) of the network subscriber (7) compared to a reference clock (10) of the automation communication network (1) is taken into account by adjusting at least one increment of the sequence of increments.

5. The method according to any one of the preceding claims, wherein incrementing of the internal clock (8) is repeated by means of the sequence of integer increments.

6. A network subscriber (7),
which is provided for exchanging data with further network subscribers (2) in an automation communication network (1) with a predetermined clock frequency,
wherein the network subscriber (7) comprises an internal clock (8) for synchronizing the data exchange with at least one further network subscriber (7),
wherein the internal clock (8) is embodied to provide a time as an integer count value,
wherein the clock frequency is determined such that a period duration per clock pulse cannot be represented as an integer count value by the internal clock (8),
wherein the network subscriber (7) comprises an internal control device,
wherein the internal control device is embodied to increment the internal clock (8) by means of a set sequence of integer increments,
wherein the sequence of integer increments is determined such a way that a sum of the integer increments corresponds to an integer multiple of the period duration.

7. An automation communication network
comprising at least two network subscribers (7) according to claim 6,
wherein the network subscribers (7) are connected to one another via a field bus (3) for exchanging data, wherein the network subscribers (7) are connected to a control device (50) of the automation communication network (1).

## Revendications

1. Procédé pour faire fonctionner un périphérique de réseau (7) dans un réseau de communication d'automatisation (1),
le périphérique de réseau (7) étant conçu pour échanger des données avec d'autres périphériques de réseau (2) dans le réseau de communication d'automatisation (1) avec une fréquence cyclique spécifiée,
le périphérique de réseau (7) possédant une horloge interne (8) servant à la synchronisation de l'échange de données avec au moins un autre périphérique de réseau (7),
l'horloge interne (8) étant conçue pour fournir un temps sous la forme d'une valeur de comptage entière,
la fréquence cyclique étant fixée de telle sorte qu'une durée de période par cycle ne peut pas être représentée par l'horloge interne (8) par une valeur de comptage entière,
le procédé comprenant l'étape suivante :
- incrémentation de l'horloge interne (8) au moyen d'une séquence spécifiée d'incréments entiers,
la séquence d'incréments entiers étant spécifiée de telle sorte qu'une somme des incréments entiers correspond à un multiple entier de la durée de période.

2. Procédé selon la revendication 1,
la séquence d'incréments entiers étant une séquence alternée d'un premier incrément et d'un deuxième incrément,
le premier incrément étant le nombre entier le plus grand, lequel est plus petit que la durée de période,
le deuxième incrément étant le nombre entier le plus petit, lequel est plus grand que la durée de période.

3. Procédé selon la revendication 1 ou 2,
un ordre des incréments étant spécifié de telle sorte qu'après chaque cycle, un écart entre une somme des incréments des cycles déjà effectués et un multiple de la durée de période est minimal.

4. Procédé selon l'une des revendications précédentes, une dérive de l'horloge interne (8) du périphérique de réseau (7) par rapport à une horloge de référence (10) du réseau de communication d'automatisation (1) étant prise en considération par l'adaptation d'au moins un incrément de la séquence d'incréments.

5. Procédé selon l'une des revendications précédentes, l'incrémentation de l'horloge interne (8) étant répétée au moyen de la séquence d'incréments entiers.

6. Périphérique de réseau (7),
lequel est conçu pour échanger des données avec d'autres périphériques de réseau (2) dans un réseau de communication d'automatisation (1) avec une fréquence cyclique spécifiée,
le périphérique de réseau (7) possédant une horloge interne (8) servant à la synchronisation de l'échange de données avec au moins un autre périphérique de réseau (7),
l'horloge interne (8) étant conçue pour fournir un temps sous la forme d'une valeur de comptage entière,
la fréquence cyclique étant fixée de telle sorte qu'une durée de période par cycle ne peut pas être représentée par l'horloge interne (8) par une valeur de comptage entière,
le périphérique de réseau (7) possédant une unité de commande interne,
l'unité de commande interne étant configurée pour incrémenter l'horloge interne (8) au moyen d'une séquence spécifiée d'incréments entiers,
la séquence d'incréments entiers étant spécifiée de telle sorte qu'une somme des incréments entiers correspond à un multiple entier de la durée de période.

7. Réseau de communication d'automatisation, comprenant au moins deux périphériques de réseau (7) selon la revendication 6,
les périphériques de réseau (7) étant reliés l'un à l'autre par le biais d'un bus de terrain (3) pour l'échange de données,
les périphériques de réseau (7) étant reliés à une unité de commande (50) du réseau de communication d'automatisation (1).
